# EUROPÄISCHE PATENTANMELDUNG

(11) **EP 0 602 276 A1**
(43) Veröffentlichungstag der Anmeldung: **22.06.1994**
(21) Anmeldenummer: 92121626.3
(22) Anmeldetag: 18.12.1992
(51) Int. Cl.: G06F 12/06

(54) **Programmierbare Adre dekoder**

(71) Anmelder: Siemens Nixdorf Informationssysteme Aktiengesellschaft, D-33102 Paderborn (DE)
(72) Erfinder: Möhring, Herman, Dipl.-Ing. (FH), W-8901 Königsbrunn (DE)
(74) Vertreter: Fuchs, Franz-Josef, Dr.-Ing.

(57) **Zusammenfassung**

Es wird eine Vorrichtung zum Umsetzen von Eingangssignalen in vorgegebene Ausgangssignale in Rechnersystemen vorgeschlagen, die es erlaubt, eine Software nicht an die Hardware sondern die Hardware an die Software eines Rechnersystems anzupassen. Kernstück der Realisierung ist eine les- und beschreibbare Speichereinheit (LBSP), die frei programmiert werden kann und alle Informationen enthält, um beispielsweise Funktionseinheiten (FK) und Teilspeichermodule von Arbeitsspeichern eines Rechnersystems zu aktivieren und ihnen Attribute zuzuweisen. Außerdem kann eine lineare und lückenlose Adressierung eines aus mehreren Teilspeichermodulen bestehenden Arbeitsspeichers sichergestellt werden, unabhängig davon, welche Teilspeichermodule an welchen Einbauplätzen verwendet werden. Die Vorrichtung kann dynamisch rekonfiguriert werden.

## Beschreibung

Die Erfindung betrifft eine Vorrichtung zum Umsetzen von Eingangssignalen in vorgegebene Ausgangssignale in Rechnersystemen gemäß dem Oberbegriff des Anspruchs 1.

Ein Rechnersystem mit zugehörigen Funktionseinheiten und einem Arbeitsspeicher, der in einzelne Speicherbanken unterteilt ist, arbeitet in der Weise, daß wenigstens die Funktionseinheiten mit ihren spezifischen Funktionen über vorgegebene Adressen angesprochen werden. Zum Beispiel wird eine Uhrenfunktion über eine Adresse X, eine Ausgabefunktion über eine Adresse Y und eine Eingabefunktion über eine Adresse Z aktiviert. Hierzu wird die Adresse über einen Adreßdekoder geleitet, der aus den Adreßsignalen vorgegebene Ausgangssignale ableitet, mit denen dann die jeweiligen Funktionseinheiten wenigstens aktiviert werden. Chip-Select-Signale sind ein Beispiel für solche Ausgangssignale.

Adreßdekoder werden heute beispielsweise mit EPROM-Bausteinen oder PAL-Bausteinen realisiert. Auch festprogrammierte Logiken werden eingesetzt. Immer aber ist der Adreßdekoder eine festprogrammierte Einheit, die eine fest vorgegebene Systemkonfiguration mit entsprechenden Parametereinstellungen des Rechnersystems beschreibt. Zum Rechnersystem passende Software trägt diesem Umstand Rechnung. Sie läuft deshalb sicher nur in Kombination mit diesem Rechnersystem.

Die Software ist heute mit am kostenintensivsten. Es wird deshalb angestrebt, daß eine Software möglichst unabhängig von einem speziellen Rechnersystem auf möglichst vielen Rechnersystemen ablauffähig ist. Um dies zu erreichen, arbeitet heute eine Software beispielsweise mit Listen, in denen die zu einem in Frage kommenden Rechnersystem benötigten Parameter festgehalten sind. Unter Parameter werden in diesem Zusammenhang beispielsweise die Adressen verstanden, über die die einzelnen Funktionseinheiten des betreffenden Rechnersystems angesprochen werden können. Die Listen können aber nie alle in Frage kommenden Rechnersysteme berücksichtigen. Das heißt, eine optimale Nutzung von Software im Sinne von einer Anwendbarkeit auf jeweils möglichst allen Rechnersystemen ist nicht gegeben.

Ein anderes Problem stellt die heute mögliche Speichererweiterung von in Teilmodulen unterteilten Arbeitsspeichern in Rechnersystemen dar. Der relativ teure Arbeitsspeicher wird in der Regel nicht von Anfang an mit allen Teilmodulen ausgerüstet. Vielmehr werden Teilmodule bei Bedarf und nach Bedarf nachgerüstet. Der Arbeitsspeicher ist dabei zweckmäßigerweise in Teilmodule unterschiedlicher Größen unterteilt, um die Speicherkapazität besser an den Bedarf anpassen zu können. Unabhängig vom Ausbau des Arbeitsspeichers muß aber jeweils sichergestellt werden, daß immer eine lineare und lückenlose Adressierung des aktuellen Arbeitsspeichers gewährleistet ist. Hierzu kann es notwendig sein, daß die einzelnen Teilmodule in Steckplätzen mit einer Rangordnung beginnend bei einer niedrigsten Rangordnung eingesteckt werden. Es kann auch nötig sein, daß Teilmodule mit kleinerer Speicherkapazität vor solchen mit größerer Speicherkapazität angeordnet werden. Ferner kann es notwendig sein, daß einzelne Teilmodule in ausgewählten Steckplätzen eingesteckt werden. Schließlich kann es sein, daß eine Vielzahl von kleinen Brückensteckern in zeitaufwendiger Handarbeit einzeln entsprechend gesteckt werden müssen. All dies ist umständlich und birgt die Gefahr von Fehlern in sich.

Aufgabe der Erfindung ist es deshalb, für alle Arten von Rechnersystemen eine Vorrichtung der eingangs genannten Art anzugeben, durch die eine Software auf dem jeweiligen Rechnersystem ablauffähig ist. Außerdem soll die Handhabung bei einer Speichererweiterung eines in Teilmodulen unterteilten Arbeitsspeichers des jeweiligen Rechnersystems vereinfacht und eine lineare und lückenlose Adressierung des jeweils aktuellen Speicherbereichs sichergestellt werden.

Diese Aufgabe wird durch die im Anspruch 1 gekennzeichneten Merkmale gelöst.

Eine danach ausgebildete Vorrichtung weist einen entsprechenden Einbauplatz für eine les- und beschreibbare Speichereinheit auf, die die vollständige Information zur Lösung der Aufgabe enthält. Die Vorrichtung ist eine programmierbare bzw. frei einstellbare Board/Systemkonfiguration bzw. Hardware/Software Schnittstelle, die bei Rechnersystemen aller Art verwendet werden kann. Mit dieser Vorrichtung ist ein Rechnersystem an eine Software anpaßbar, auch wenn diese ursprünglich nicht für das vorliegende Rechnersystem geschrieben wurde. Eine Anpassung der Software an das Rechnersystem ist nicht mehr notwendig.

Die Anpassung des Rechnersystems an die Software ist möglich, weil die Zugriffsadressen der verschiedenen Funktionseinheiten des Rechnersystems frei gewählt werden können. Zusätzlich können zu den adressierten Funktionseinheiten Zusatzinformationen, sogenannte Attribute, frei definiert werden. Ein weiterer Vorteil ist, daß durch die Vorrichtung die Möglichkeit einer dynamischen Rekonfigurierung des Rechnersystems besteht. Beispielsweise können die Attribute, die die Cache-Fähigkeit von Speicherbereichen des Arbeitsspeichers angeben, dynamisch verändert werden.

Ferner können die Startadressen von den den Arbeitsspeicher bildenden Teilmodulen frei gewählt werden. Damit können die einzelnen Teilmodule in beliebiger Reihenfolge, an beliebigen Steckplätzen und, sofern es der Ausbau erlaubt, in beliebiger Größe eingesteckt werden. Die Handhabung bei einer Speichererweiterung wird damit wesentlich erleichtert, da die obengenannten Maßnahmen zum Bewerkstelligen einer linearen und lückenlosen Adressierung des Arbeitsspeichers entfallen. Dieses wird nunmehr sehr einfach durch eine entsprechende Programmierung der Startadressen der verwendeten Teilmodule erreicht. Ein weiterer Vorteil ist, daß eine dynamische Rekonfigurierung des Fehler-Modus zu einem jeweiligen Teilmodul des Arbeitsspeichers möglich ist. Der Fehler-Modus gibt an, ob der Speicherbereich eines betreffenden Teilmoduls beispielsweise ECC oder Parity gesichert werden soll.

Eine in Empfangs- und Senderichtung arbeitende Pufferanordnung zum Beschreiben und Lesen der les- und beschreibbaren Speicheranordnung ermöglicht neben der Programmierung auch das Testen der les- und beschreibbaren Speichereinheit.

Vorteilhafte Ausgestaltungen der Erfindung sind Gegenstand von Unteransprüchen.

Eine einem Entschlüsselungsbaustein vorgeschaltete Fehlerüberwachungseinrichtung überprüft die dem betreffenden Entschlüsselungsbaustein zugeleiteten Signale zum Beispiel auf Fehler oder allgemeine Gültigkeit. Sie können zum Melden von Fehlern oder umschalten von Signalen verwendet werden. Beispielsweise kann der Fall gegeben sein, daß über zwei unabhängige Signale vier Funktionseinheiten adressierbar, im Augenblick aber nur drei angeschlossen sind. In einem solchen Fall könnte die vierte Kombination dazu benutzt werden, eine Fehlermeldung auszulösen oder auf eine gültige Kombination umzuschalten, so daß eine der vorhandenen Funktionseinheiten angesprochen wird. Dadurch wird verhindert, daß ein Rechnersystem abstürzt, weil eine Antwort von einer nicht vorhandenen Funktionseinheit ausbleibt.

Eine dynamische Seitengröße-Auswahlschaltung hat den Vorteil, daß bei der Programmierung der les- und beschreibbaren Speichereinheit eine 1:1 Adressenzuordnung gewählt werden kann. Im laufenden Betrieb muß eine Systemadresse nicht direkt an die les- und beschreibbare Speichereinheit angelegt sondern kann nach vorgegebenen Kriterien abgeändert werden. Diese Maßnahme reduziert die Speichertiefe der les- und beschreibbaren Speichereinheit erheblich, da jedem Eintrag in der les- und beschreibbaren Speichereinheit auch große System-Adreß-Bereiche zugeordnet werden können.

Die Seitengröße kann wiederum eine Funktion der System-Adresse sein. Somit kann es Adreß-Bereiche mit großer und kleiner Granularität geben, die den Funktionseinheiten zuordenbar sind.

Zusätzlich können Systemattribute wie READ/WRITE und MEMORY/IO zur Ansteuerung der les- und beschreibbaren Speichereinheit dienen.

Alle diese Maßnahmen ergeben ein Höchstmaß an Flexibilität.

Ein der dynamischen Seitengröße-Auswahlschaltung nachgeschalteter Zwischenspeicher erhöht die Funktionssicherheit gegenüber Systemstörungen erheblich.

Werden für einen festgelegten Fall anstelle einer les- und beschreibbaren Speichereinheit festprogrammierte Speicherelemente verwendet, können die Kosten für die Vorrichtung gesenkt werden.

Zum schnellen Umrüsten zwischen einer Lösung entweder mit les- und beschreibbarer Speichereinheit oder mit festprogrammierten Speicherelementen ist es vorteilhaft, wenn die betreffenden Bauteile beispielsweise steckbar angeordnet sind.

Nachfolgend wird ein Ausführungsbeispiel der Erfindung anhand einer Zeichnung näher erläutert.

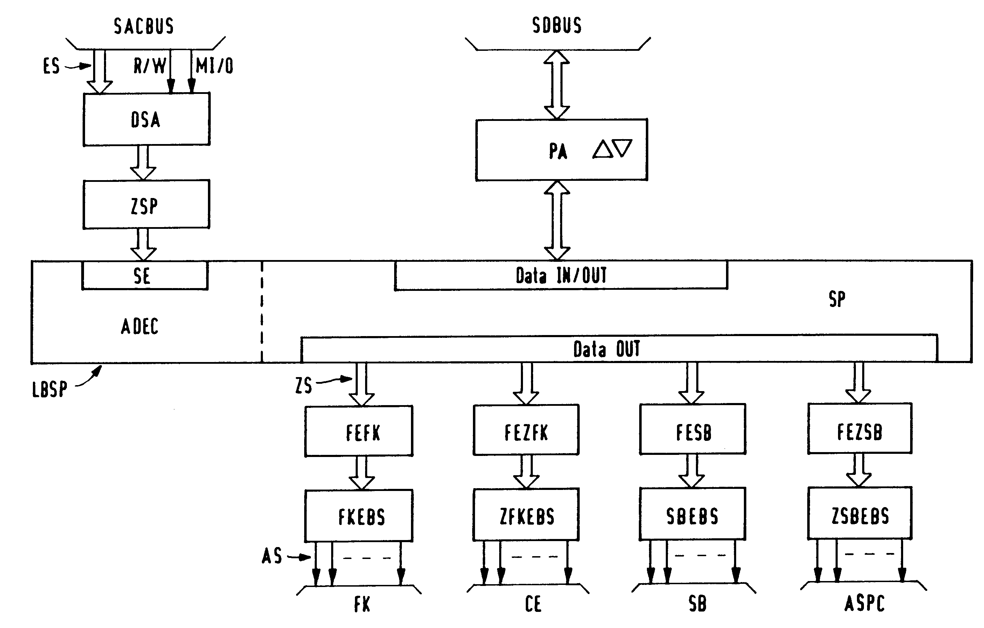

Die einzige Figur zeigt eine Vorrichtung zum Umsetzen von Eingangssignalen in vorgegebene Ausgangssignale gemäß der Erfindung in Prinzipdarstellung.

Zu sehen ist eine wahlfreie les- und beschreibbare Speichereinheit LBSP, die das Kernstück der dargestellten Vorrichtung bildet. Die les- und beschreibbare Speichereinheit LBSP weist einen Adreßdekoderteil ADEC und einen Speicherteil SP auf. Dem Adreßdekoderteil ADEC sind Steuereingänge SE zugeordnet. Über die Steuereingänge SE können die einzelnen Speicherplätze der les- und beschreibbaren Speichereinheit LBSP angesprochen werden. Dem Speicherteil SP sind Datenein/ausgänge Data IN/OUT zugeordnet. Die Datenein/ausgänge Data IN/OUT sind hier zusammengefaßt, so daß ein Dateneinlesen und ein Datenauslesen über die gleichen Anschlüsse erfolgen kann. Sie könnten auch getrennt nach ihrer Funktion ausgebildet sein. Ein Auslesen der Einträge im Speicherteil SP kann zum Uberprüfen der Speicherinhalte dienen. Der Speicherteil SP weist außer den Datenein/ausgängen Data IN/OUT noch Datenausgänge Data OUT auf, die zum Weiterleiten von als Zwischensignale ZS ausgegebenen Daten dienen.

In der les- und beschreibbaren Speichereinheit LBSP ist die vollständige Information gespeichert, die notwendig ist, um Funktionseinheiten eines zugrundeliegenden Rechnersystems auswählen und einstellen zu können. Jeder Eintrag in der les- und beschreibbaren Speichereinheit LBSP enthält beispielsweise die Information darüber, welche physikalische Funktionseinheit wie EPROM-Baustein, SCSI-Controller, Speicher usw. ausgewählt werden soll. Ferner enthält jeder Eintrag die Information darüber, welche Attribute wie z.B. Cache-Fähigkeit, nur Lesbarkeit, Durchschreibbarkeit, Fehlerkondition usw. für eine physikalische Funktionseinheit gelten sollen. Außerdem enthält jeder Eintrag die Information darüber, ob und dann welches Teilspeichermodul eines in Teilspeichermodule unterteilten Arbeitsspeichers eines zugrundeliegenden Rechnersystems ausgewählt und welche Fehlerüberwachung und Fehlerkorrektur hierfür aktiviert werden soll.

An die Steuereingänge SE der les- und beschreibbaren Speichereinheit LBSP sind Eingangssignale ES zum Adressieren der einzelnen Speicherplätze geführt. Die Eingangssignale ES werden über einen Systemadreß- und Controllbus SACBUS zugeleitet, der Teil eines zugrundeliegenden Rechnersystems ist. Die Eingangssignale ES setzen sich im Ausführungsbeispiel neben Adressen darstellenden Leitungen, die vom Adreßteil des Systemadreß- und Controllbusses SACBUS abstammen, aus den vom Kontrollteil des Systemadreß- und Controllbus SACBUS abstammenden Kontrolleitungen Lesen/Schreiben R/W oder Speicher-IN/OUT MI/O zusammen.

Im Ausführungsbeispiel ist den Steuereingängen SE der les- und beschreibbaren Speichereinheit LBSP eine dynamische Seitengröße-Auswahlschaltung DSA und ein Zwischenspeicher ZS vorgeschaltet. Die Eingangssignale ES sind dabei zuerst über die dynamische Seitengröße-Auswahlschaltung DSA und dann über den Zwischenspeicher ZS geführt, bevor sie auf die Steuereingänge SE der les- und beschreibbaren Speichereinheit LBSP geführt sind.

Sowohl die dynamische Seitengröße-Auswahlschaltung DSA als auch der Zwischenspeicher ZS können gegebenenfalls weggelassen werden. Die dynamische Seitengröße-Auswahlschaltung ist dann nicht notwendig, wenn eine übergeordnete Software die an die les- und beschreibbare Speichereinheit LBSP anzulegenden Adressen mit entsprechender Funktion steuern kann. Der Zwischenspeicher ZS ist beispielsweise dann nicht notwendig, wenn auf einen geschachtelten Prozeßablauf verzichtet wird oder wenn Leitungsstörungen nicht zu erwarten sind.

Die dynamische Seitengröße-Auswahlschaltung DSA kann durch eine logische Anordnung beispielsweise bestehend im wesentlichen aus einem Multiplexer oder einem Barrel-Shifter gebildet sein. Ist die dynamische Seitengröße-Auswahlschaltung DSA aus einem Multiplexer gebildet, kann dieser ausgehend von beispielsweise 32 Adreßleitungen und den Kontrolleitungen Lesen/Schreiben R/W und Speicher-IN/OUT MI/O, die als Eingangssignale ES von dem System- und Controllbus SACBUS bereitgestellt werden, in der Weise beschaltet sein, daß die Adreßleitungen 0 bis 9 einer ersten Gruppe von Auswahleingängen, die Adreßleitungen 11 bis 20 einer zweiten Gruppe von Auswahleingängen, die Adreßleitungen 22 bis 31 einer dritten Gruppe von Auswahleingängen und die Kontrolleitungen Lesen/Schreiben R/W und Speicher-IN/OUT MI/O zwei Steuereingängen, über die eine der drei beschalteten Gruppen von Auswahleingängen ausgewählt und auf eine entsprechende Gruppe von Ausgängen durchgeschaltet werden können, zugeführt sind. Damit läßt sich der über die 32 Adreßleitungen ansprechbare Adreßraum komprimieren und in den verschiedenen Adreßbereichen unterschiedlich granulieren.

Der Zwischenspeicher ZS kann beispielsweise durch Registerelemente gebildet sein, die die Eingangssignale durchschalten und dann vom Ausgang abkoppeln. Nachdem der Zwischenspeicher ZS durchgeschaltet hat, können sich die Eingangssignale ohne weitere Auswirkung auf die Adressierung der les- und beschreibbaren Speichereinheit LBSP ändern. Geschachtelte Prozeßabläufe können damit realisiert werden.

An den Datenein/ausgängen Data IN/OUT der les- und beschreibbaren Speichereinheit LBSP ist eine in Empfangs- und Senderichtung arbeitende Pufferanordnung PA angeschlossen, die wiederum mit einem Systemdatenbus SDBUS eines zugrundeliegenden Rechnersystems verbunden ist. Die Pufferanordnung PA kann durch an sich bekannte Treiberschaltungen gebildet sein.

An den Datenausgängen Data OUT sind über die Breite der Datenausgänge Data OUT mehrere Entschlüsselungsbausteine FKEBS, ZFKEBS, SBEBS, ZSBEBS angeschlossen, die jeweils mit einem Teil der Datenausgänge Data OUT verbunden sind. Die Entschlüsselungsbausteine FKEBS, ZFKEBS, SBEBS, ZSBEBS erzeugen aus den von der les- und beschreibbaren Speichereinheit LBSP ausgegebenen Zwischensignalen ZS Ausgangssignale AS, die die Funktionseinheiten FK eines zugrundeliegenden Rechnersystems aktivieren und einstellen. Im einzelnen sind die Entschlüsselungsbausteine FKEBS, ZFKEBS, SBEBS, ZSBEBS Dekoder, von denen ein erster FKEBS für die Aktivierung der durch die Eingangssignale ES adressierten Funktionseinheiten FK, ein zweiter ZFKEBS für die Zuordnung von Zusatzinformationen zu den Funktionseinheiten FK, ein Dritter SBEBS für die Auswahl von Speicherbanken SB eines entsprechend unterteilten Arbeitsspeichers und ein vierter ZSBEBS für die Zuordnung von Zusatzinformationen zu den durch die Eingangssignale ES adressierten Speicherbanken SB vorgesehen ist.

Die vom ersten Entschlüsselungsbaustein FKEBS erzeugten Signale aktivieren einzeln beispielsweise EPROM-Bausteine, PORTS, FLOPPY-Einheiten oder SCSI-Baugruppen eines Rechnersystems. Die vom zweiten Entschlüsselungsbaustein ZFKEBS erzeugten Signale weisen jeweils ein Attribut zu einer ausgewählten Funktionseinheit FK zu. Sie werden gemeinschaftlich jeweils auf BUS-MASTER-Baugruppen wie z.B eine CPU oder ein DMA-Controller geführt. Die einzelnen Signale des dritten Entschlüsselungsbausteins SBEBS sind auf die einzelnen Speicherbanken eines Arbeitsspeichers eines Rechnersystems geführt. Die einzelnen Signale des vierten Entschlüsselungsbausteins ZSBEBS sind auf eine Speicherbanken-Controlleinrichtung ASPC geführt und weisen den einzelnen Speicherbanken Attribute zu. Ein Attribut könnte angeben, ob für eine jeweilige Speicherbank ein ECC-Fehlermodus oder ein Parity-Fehlermodus gelten soll.

Den einzelnen Entschlüsselungsbausteinen FKEBS, ZFKEBS, SBEBS, ZSBEBS sind Fehlerüberwachungseinrichtungen FEFK, FEZFK, FESB, FEZSB vorgeschaltet.

Wie schon erwähnt, übernimmt der erste Entschlüsselungsbaustein FKEBS die binär kodierte Information aus der les- und beschreibbaren Speichereinheit LBSP, dekodiert diese und aktiviert damit die physikalischen Funktionseinheiten FK. Sollte die binär dekodierte Information nicht vollständig ausdekodiert sein, ist die dem ersten Entschlüsselungsbaustein FKEBS vorgeschaltete Fehlerüberwachungseinrichtung FEFK notwendig um die nicht ausdekodierten Signale herauszufiltern. Ansonsten könnte die Fehlerüberwachungseinrichtung auch entfallen.

Entsprechendes gilt für den zweiten Entschlüsselungsbaustein ZFKEBS und für die diesem vorgeschaltete Fehlerüberwachungseinrichtung FEZFK. Die gerade erwähnte Fehlerüberwachungseinrichtung FEZFK kann durch eine entsprechende Überwachungssoftware eines zugrundeliegenden Rechnersystems ersetzt werden und damit entfallen.

Sollte der erste Entschlüsselungsbaustein FKEBS den Arbeitsspeicher eines Rechnersystems als physikalisches Element ausgewählt haben, so wählt der dritte Entschlüsselungsbaustein SBEBS aus der binären Information, die in den Zwischensignalen ZS der les- und beschreibbaren Speichereinheit LBSP enthalten ist, ein Teilspeichermodul bzw. eine Speicherbank SB aus. Sollte der Code für die Auswahl eines Teilspeichermoduls oder einer Speicherbank SB nicht vollständig ausdekodiert sein, so ist die dem dritten Entschlüsselungsbaustein SBEBS vorgeschaltete Fehlerüberwachungseinrichtung FESB notwendig. Ansonsten könnte auch sie entfallen.

Zu jeder Speicherbank SB wird eine Information über die ausgewählte Fehlerauswertung bzw. dem gewählten Testmodus benötigt. Dies wird der Speicherbanken-Controlleinrichtung ASPC vom vierten Entschlüsselungsbaustein ZSBEBS zur Verfügung gestellt. Die vorgeschaltete Fehlerüberwachungseinrichtung FEZSB filtert wieder nicht erlaubte Kombinationen aus. Gibt es nur erlaubte Kombinationen, könnte auch diese Fehlerüberwachungseinrichtung entfallen.

Für die les- und beschreibbare Speichereinheit LBSP kann ein statisches Speicherelement verwendet werden. Dieses Speicherelement ermöglicht eine dynamische Umprogrammierung während des normalen Betriebs. Es kann dadurch eine beliebige physikalische Funktionsbaugruppe einer beliebigen Adresse zugeordnet werden. Hierdurch ist neben der heute schon üblichen virtuellen Speicheradressierung auch eine virtuelle Adressierung von Funktionsbaugruppen möglich.

## Patentansprüche

1. Vorrichtung zum Umsetzen von in einem Rechnersystem mit Funktionseinheiten (FK) und Speicherbanken (SB) aufweisenden Arbeitsspeichern wenigstens die Funktionseinheiten (FK) des Rechnersystems adressierenden Eingangssignalen (ES) in vorgegebene Ausgangssignale (AS), die wenigstens eine durch die Eingangsssignale (ES) adressierte Funktionseinheit (FK) wenigstens aktivieren,
**dadurch gekennzeichnet,**
daß ein Einbauplatz vorgesehen ist für eine Funktionsbaugruppe gemäß einer les- und beschreibbaren Speichereinheit (LBSP), daß in dem Einbauplatz für die Funktionsbaugruppe gemäß der les- und beschreibbaren Speichereinheit (LBSP) eine entsprechende les- und beschreibbare Speichereinheit (LBSP) angeordnet ist mit Steuereingängen (SE), mit Datenein- und Datenausgängen oder Datenein/ausgängen (Data IN/OUT) zum Lesen und Beschreiben der les- und beschreibbaren Speichereinheit (LBSP) und mit Datenausgängen (Data OUT) zum Weiterleiten von als Zwischensignale (ZS) ausgegebenen Daten,
daß der Einbauplatz für die Funktionsbaugruppe gemäß der les- und beschreibbaren Funktionsbaugruppe (LBSP) in der Weise beschaltet ist, daß bei der in dem Einbauplatz angeordneten les- und beschreibbaren Speichereinheit (LBSP) die Eingangssignale (ES) auf die Steuereingänge (SE) geführt sind, die Datenein- und Datenausgänge oder Datenein/ausgänge (Data IN/OUT) mit einer in Empfangs- und Senderichtung arbeitenden Pufferanordnung (PA) und die Datenausgänge (Data OUT) für die Weiterleitung von als Zwischensignale (ZS) ausgegebenen Daten mit nachfolgenden Einheiten zur Erzeugung der Ausgangssignale (AS) verbunden sind, und
daß die nachfolgenden Einheiten zur Erzeugung der Ausgangssignale (AS) durch Entschlüsselungsbausteine (FKEBS, ZFKEBS, SBEBS, ZSBEBS) gebildet sind, die jeweils mit einem Teil der Datenausgänge (Data OUT) der in dem Einbauplatz für die les- und beschreibbare Speichereinheit (LBSP) angeordneten les- und beschreibbaren Speichereinheit (LBSP) verbunden sind und von denen ein erster Entschlüsselungsbaustein (FKEBS) für die Aktivierung einer durch die Eingangssignale (ES) adressierten Funktionseinheit (FK), ein zweiter (ZFKEBS) für eine Zuordnung von Zusatzinformationen zu der durch die Eingangssignale (ES) adressierten Funktionseinheit (FK), ein dritter (SBEBS) für eine Auswahl von Speicherbanken (SB) der Arbeitsspeichereinheit des Rechnersystems und ein vierter (ZSBEBS) für eine Zuordnung von Zusatzinformationen zu den durch die Eingangssignale (ES) adressierten Speicherbanken (SB) der Arbeitsspeichereinheit des Rechnersystems vorgesehen ist.

2. Vorrichtung nach Anspruch 1,
**dadurch gekennzeichnet,**
daß wenigstens einem der Entschlüsselungsbausteine (FKEBS; ZFKEBS; SBEBS; ZSBEBS) eine Fehlerüberwachungseinrichtung (FEFK; FEZFK; FESB; FEZSB) vorgeschaltet ist.

3. Vorrichtung nach Anspruch 1 oder 2,
**dadurch gekennzeichnet,**
daß vor dem Einbauplatz für die Funktionsbaugruppe gemäß der les- und beschreibbaren Speichereinheit (LBSP) eine dynamische Seitengröße-Auswahlschaltung (DSA) angeordnet ist, die mit den Eingangssignalen (ES) zuerst verbunden ist, bevor die Steuereingänge (SE) der Funktionseinheit gemäß der les- und beschreibbaren Speichereinheit (LBSP) mit den Eingangssignalen (ES) verbunden sind.

4. Vorrichtung nach Anspruch 3,
**dadurch gekennzeichnet,**
daß zwischen der dynamischen Seitengröße-Auswahlschaltung (DSA) und dem Einbauplatz für die Funktionsbaugruppe gemäß der les- und beschreibbaren Speichereinheit (LBSP) an der Stelle, an der die Steuereingänge (SE) der les- und beschreibbaren Speichereinheit (LBSP) mit der dynamischen Seitengröße-Auswahlschaltung (DSA) verbunden ist, ein Zwischenspeicher (ZSP) angeordnet ist.

5. Vorrichtung nach einem der vorherigen Ansprüche,
**dadurch gekennzeichnet,**
daß der Einbauplatz für die Funktionseinheit gemäß der les- und beschreibbaren Speichereinheit (LBSP) in der Weise ausgebildet ist, daß die Funktionseinheit gemäß der les- und beschreibbaren Speichereinheit (LBSP) austauschbar ist.

6. Vorrichtung nach einem der vorherigen Ansprüche,
**dadurch gekennzeichnet,**
daß im Einbauplatz für die Funktionsbaugruppe gemäß der les- und beschreibbaren Speichereinheit (LBSP) eine Funktionsbaugruppe mit festprogrammierten Speicherelementen angeordnet ist, die wenigstens bezüglich der Steuereingänge (SE), der Datenausgänge (Data OUT) und der dazwischenliegenden Funktion wie die les- und beschreibbare Speichereinheit (LBSP) ausgebildet ist.
